# FASCICULE DE BREVET EUROPEEN

(11) **EP 0 655 784 B1**
(45) Date de publication et mention de la délivrance du brevet: **17.10.2001**
(21) Numéro de dépôt: 94410107.0
(22) Date de dépôt: 25.11.1994
(51) Int. Cl.: H01L 29/87, H01L 27/08

(54) **Composant de protection semi-conducteur comprenant des diodes de Shockley**
Halbleiter-Schutzbauelement mit Shockley-Dioden
Semiconductor protection component having Shockley diodes

(30) Priorité: 29.11.1993 FR 9314553
(43) Date de publication de la demande: 31.05.1995
(73) Titulaire: STMicroelectronics S.A., 94250 Gentilly (FR)
(72) Inventeur: Bernier, Eric, 37390 Mettray (FR); Ballon, Christian, F-37000 Tours (FR)
(74) Mandataire: de Beaumont, Michel

(56) Documents cités:
- EP-A- 0 472 405
- WO-A-87/06768
- FR-A- 2 453 522
- GB-A- 2 184 884
- US-A- 4 282 555
- US-A- 4 905 119

## Description

La présente invention concerne un composant semi-conducteur de protection contre des surtensions destiné à être connecté à deux lignes à protéger et à la masse et plus particulièrement un tel composant constituant une diode de Shockley bidirectionnelle entre chacune des lignes et entre chaque ligne et la masse selon une configuration triangle. De tels composants (voir GB-A-2184884 ou WO-A-87/06768) sont par exemple destinés à la protection de lignes téléphoniques contre des surtensions dues à des coups de foudre ou à une mise en contact accidentelle avec une ligne à haute tension.

La demande de brevet intercalaire EP-A-0600810 (Ugge et Pezzani) concerne un composant monolithique de ce type et s'intéresse plus particulièrement au problème du reblocage du composant à la suite d'une surtension en tenant compte du fait que les deux conducteurs d'une ligne téléphonique sont généralement polarisés à des potentiels de -48V et -2V.

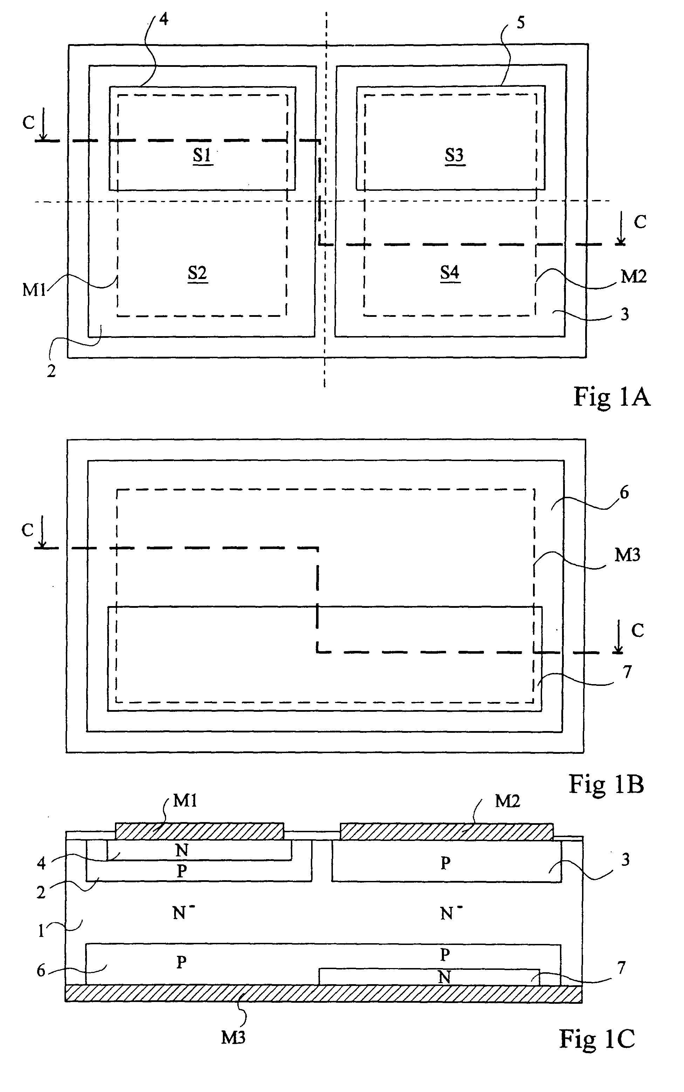

Les figures 1A, 1B et 1C rappellent la structure d'un tel composant. La figure 1A représente une vue de dessus, la figure 1B une vue de dessous retournée et la figure 1C une vue en coupe selon la ligne CC des figures LA et 1B. Ce composant est construit à partir d'un substrat de silicium 1 de type N très faiblement dopé (N⁻). Dans la surface supérieure du substrat sont diffusés deux caissons 2 et 3 de type P. A l'intérieur du caisson 2 est diffusée une région 4 de type N et à l'intérieur du caisson 3 est diffusée une région 5 de type N. Les régions 4 et 5 occupent chacune sensiblement la moitié de la surfaoe des caissons correspondants 2 et 3. Dans sensiblement toute la surface de la face arrière du composant est diffusée une région 6 de type P. Dans la région 6 est diffusée une région 7 de type N qui occupe sensiblement une surface complémentaire de oelle de la projection des régions 4 et 5 perpendiculairement au plan de la surfaoe principale du composant.

Une métallisation M1 recouvre la surface supérieure du caisson 2 et de la région 4 qui y est formée. Une métallisation M2 recouvre le caisson 3 et la région 5 qui y est formée. Une métallisation M3 recouvre la face arrière du oomposant.

En outre, comme cela est exposé dans la demande de brevet susmentionnée, les régions 4, 5 et 7 sont munies de courts-circuits d'émetteur (non représentés), c'est-à-dire que ces régions sont interrompues par emplacements et qu'au niveau de ces emplacements des portions des caissons sous-jacents affleurent en surface. La façon dont les densités de ces courts-circuits d'émetteur doivent être optimisées est également décrite dans la demande de brevet susmentionnée.

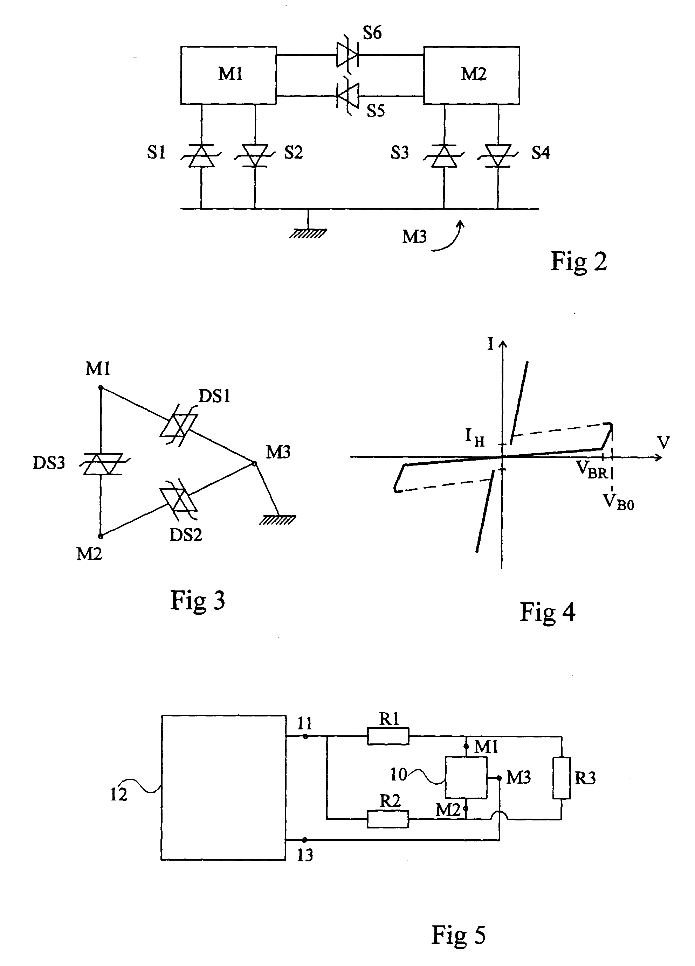

La figure 2 représente un schéma équivalent du composant des figures 1A à 1C. Ce composant est équivalent à une association de six structures à quatre couches de types de conductivité alternés, couramment appelées diodes de Shockley ou thyristors sans gâchette.

Une première diode de Shockley S1 est formée entre les métallisations M1 et M3, son anode étant du côté de la métallisation M3, et comprend successivement la région 4 de type N, le caisson 2 de type P, le substrat 1 de type N et la région 6 de type P.

Une deuxième diode de Shockley S2 en anti-parallèle sur la diode S1 est également formée entre les métallisations M1 et M3. Cette diode de Shockley oomprend les régions successives suivantes : caisson 2, substrat 1, caisson 6 et région 7.

Une troisième diode de Shockley S3 est formée entre les métallisations M2 et M3, son anode étant du côté de la métallisation M3, et est constituée des régions successives suivantes : région 5, caisson 3, substrat 1 et caisson 6.

Une quatrième diode de Shockley S4 en anti-parallèle sur la diode S3 comprend les régions successives suivantes : caisson 3, substrat 1, caisson 6 et région 7.

Une diode de Shockley latérale S5 est formée entre les métallisations M1 et M2 et comprend les régions successives suivantes : région 4, caisson 2, substrat 1, caisson 3.

Enfin, une diode de Shockley S6 en anti-parallèle sur la diode de Shockley S5 est également une diode de Shockley latérale et comprend les régions successives suivantes : caisson 2, substrat 1, caisson 3, région 5.

La figure 3 représente le même schéma équivalent que celui de la figure 2 mais dans lequel les paires de diodes Shockley en anti-parallèle S1-S2, S3-S4 et S5-S6 sont illustrées sous forme de diodes de Shockley bidirectionnelles respectives DS1, DS2 et DS3.

La figure 4 représente la caractéristique courant-tension d'une diode de Shockley bidirectionnelle classique. Tant que la tension aux bornes de cette diode de Shockley bidirectionnelle reste inférieure à une tension d'avalanche ou de claquage VBR, la diode est bloquée, c'est-à-dire que le courant qui la traverse est sensiblement nul. Dès que la tension aux bornes dépasse oette valeur VBR, le courant croit rapidement, tandis que la tension augmente lentement. Quand la tension aux bornes a atteint une valeur VBO dite tension de retournement, la tension aux bornes du composant chute rapidement et le courant s'établit en fonction des caractéristiques des circuits. Le dispositif se rebloque quand le courant à ses bornes devient inférieur à un courant de maintien IH. Cette caractéristique est sensiblement symétrique par rapport à l'origine, sous réserve d'une symétrie effective de réalisation des composants qui peuvent être dissy-métrisés par des variations de dopage de certaines couches ou par une variation de densité de trous de court-circuit. Dans une application à la protection de lignes téléphoniques, le courant de maintien doit être relativement élevé (200 à 400 mA) pour permettre le reblocage du composant à la fin de la surtension. Ceci implique une densité relativement élevée de trous de court-circuit et corrélativement une différence relativement élevée entre les valeurs de la tension d'avalanche VBR et de la tension de retournement VBO.

Le composant décrit dans la demande de brevet susmentionnée et dont la structure et le fonctionnement ont été rappelés ci-dessus satisfait bien aux fonctions essentielles visées. Néanmoins, pour les réseaux téléphoniques auxquels sont notamment destinés ces composants, on définit des normes de protection de plus en plus sévères. Selon l'une de ces normes, il faut qu'en cas de surtension simultanée par rapport à la masse sur les deux conducteurs de la ligne téléphonique, les diodes de Shockley bidirectionnelles DS1 et DS2 présentent une même tension de retournement. Notamment, selon la norme, les dispositifs doivent satisfaire avec succès à un test défini par le circuit de la figure 5. Dans cette figure, le composant de protection est désigné par la référence 10. Ses bornes M1 et M2 sont connectées à une même borne 11 d'une source d'alimentation alternative 12 par l'intermédiaire de résistances respectives égales R1 et R2. La borne de masse 13 de la souroe de tension alternative 12, par exemple une source de ± 500 volts, est connectée à la borne M3 du composant 10. En outre, une résistance R3 est connectée entre les bornes M1 et M2. La norme définit des limites de montée de tension aux bornes de la résistance R3, limite qui impose en fait qu'en cas de surtension simultanée sur les diodes de Shockley bidirectionnelles DS1 et DS2, ces deux diodes se déclenchent pratiquement simultanément.

En cas de surtension positive sur les métallisations M1 et M2, ce sont les diodes de Shockley S2 et S4 qui sont actives. La jonction bloquante de ces diodes de Shockley correspond à la jonction entre le caisson inférieur 6 et le substrat 1. Puisqu'il s'agit d'une jonction continue, dès que l'avalanche se déclenche en un point de la jonction, toute la jonction devient passante et la mise en conduction des diodes de Shockley S2 et S4 est donc pratiquement simultanée.

Par contre, si une surtension négative apparait simultanément sur les métallisations M1 et M2, ce sont les diodes de Shockley S1 et S3 qui seront actives. Les jonctions bloquantes de ces diodes de Shockley sont respectivement la jonction entre le caisson 2 et le substrat 1 et la jonction entre le caisson 3 et le substrat 1. Ces jonctions sont théoriquement identiques et devraient normalement claquer simultanément. Mais, en pratique, on s'aperçoit que, si ces jonctions ont sensiblement la même valeur de tension d'avalanche VBR, elles n'ont généralement pas la même valeur de tension de retournement VBO, surtout si, comme on l'a indiqué précédemment, VBO est nettement supérieur à VBR. Ainsi, le test défini précédemment en relation avec la figure 5 amène à écarter une proportion importante des composants fabriqués et constitue en fait une opération de tri qui amène à un taux de déchets important.

La présente invention a pour objet de remédier à cet inconvénient et de prévoir un composant de protection dans lequel des diodes de Shockley bidirectionnelles connectées entre chacune des lignes à protéger et la masse présentent un déclenchement simultané ou quasi-simultané, et ce quelle que soit la polarité de la surtension aux bornes de ces diodes de Shockley bidirectionnelles.

Pour atteindre, ces objet, la présente invention prévoit un composant semi-conducteur de protection selon la revendication 1. Des modes de réalisation particuliers sont définis dans les revendications dépendantes.

Ces objets, caractéristiques et avantages ainsi que d'autres de la présente invention seront exposés en détail dans la description suivante de modes de réalisation particuliers faite à titre illustratif en relation avec les figures jointes parmi lesquelles :
les figures 1A, 1B et 1C sont respectivement une vue de dessus, une vue de dessous retournée et une vue en coupe d'un composant tel que décrit dans la demande de brevet intercalaire EP-A-0 600 810;
les figures 2 et 3 sont des schémas équivalents du composant de la figure 1 ;
la figure 4 représente la caractéristique courant-tension d'une diode de Shockley bidirectionnelle ;
la figure 5 illustre un mode de test d'un composant de protection ;
les figures 6A et 6B représentent respectivement une vue de dessus et une vue en coupe selon la ligne B-B d'un composant selon la présente invention ; et
les figures 7 à 11 sont des vues en coupe de diverses variantes d'un composant selon la présente invention.

On notera que, dans les vues de dessus et en coupe de composants semi-conducteurs, les diverses dimensions ne sont pas tracées à l'échelle ni à l'intérieur d'une figure donnée ni d'une figure à l'autre. Conformément à l'usage dans le domaine de la représentation des semi-conducteurs, les diverses dimensions sont arbitrairement contractées ou dilatées pour la simplicité de la représentation et la lisibilité des figures.

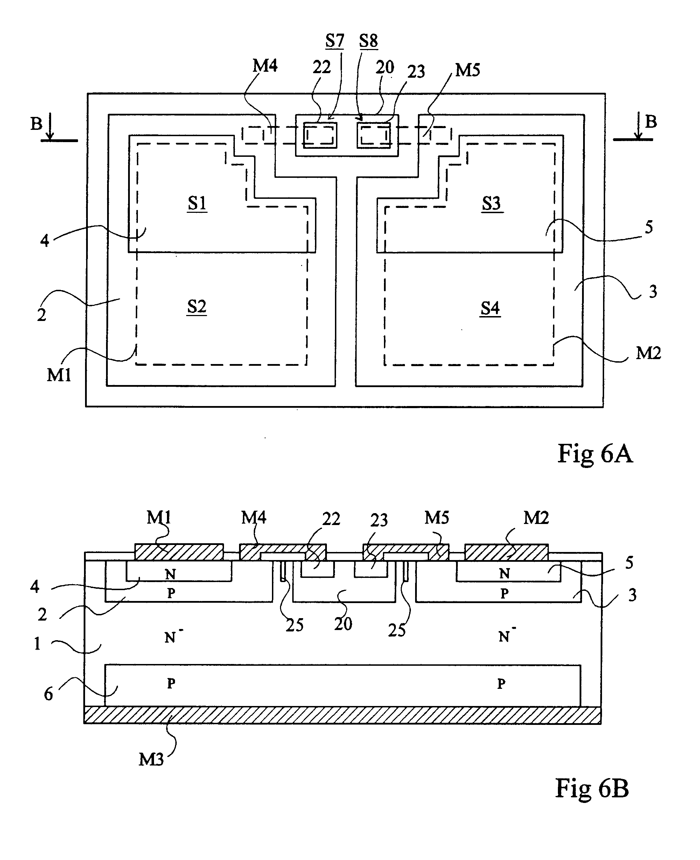

Les figures 6A et 6B représentent une vue de dessus et une vue en coupe selon la ligne B-B d'un composant modifié selon la présente invention par rapport au composant de la figure 1. Dans ces figures, de mêmes références désignent des parties similaires à celles de la figure 1. Ainsi, on retrouve dans ces figures le substrat 1, les caissons 2, 3 et 6 et les régions 4 et 5 ainsi que les métallisations M1, M2 et M3. La région 7 n'est pas visible dans ces figures mais on notera que la vue de dessous du composant de la figure 6A est identique à la vue de dessous représentée en figure 1B.

La présente invention modifie le composant décrit précédemment en rajoutant une zone d'amorçage préférentiel pour les diodes de Shockley S1 et S3, c'est-à-dire pour les diodes de Shockley correspondant respectivement aux couches et régions 4, 2, 1, 6 et 5, 3, 1, 6. Un mode de réalisation de cette zone d'amorçage préférentiel apparaît dans la partie haute de la figure 6A et dans la partie centrale de la figure 6B. Cette zone d'amorçage préférentiel comprend un caisson 20 de type P de petite dimension disposé entre les caissons 2 et 3, du côté des régions 4 et 5 de ces caissons. A l'intérieur du caisson 20, sont formées deux régions 22 et 23 de type N, respectivement connectées aux caissons 2 et 3 par des métallisations M4 et M5. Le caisson 20 est prévu pour que, quand une surtension négative survient sur les métallisations M1 et M2, la jonction bloquante entre le caisson 20 et le substrat 1 entre en avalanche avant les jonctions bloquantes entre chacun des caissons 2 et 3 et le substrat 1. Les diodes de Shockley S1 et S3 se comportent alors comme des thyristors dont les régions P respectives 2 et 3 constituent des zones de gâchette alimentées par la mise en conduction de diodes de Shockley auxiliaires respectives S7 et S8 correspondant aux régions 6-1-20-22 et 6-1-20-23. En d'autres termes, les diodes de Shockley S1 et S3 se comportent comme des thyristors à amplification de gâchette dont le retournement est très rapide dès qu'ils reçoivent un courant de gâchette.

L'homme de métier connaît de nombreux moyens pour rendre les diodes de Shockley auxiliaires S7 et S8 plus sensibles que les diodes de Shockley principales S1 et S3.

Dans le cas du dispositif illustré en figures 6A et 6B, cette augmentation de sensibilité résulte du fait que les régions 22 et 23 sont exemptes de courts-circuits d'émetteur tandis que les régions 4 et 5 sont munies de courts-circuits d'émetteur (non représentés). Du fait que les régions 22 et 23 ne oomprennent pas de courts-circuits d'émetteur, les diodes de Shockley auxiliaires auront un courant de maintien plus faible que les diodes de Shockley principales S1 et S3. Toutefois, ceci ne constitue pas un inconvénient puisque, dès que les diodes principales S1 et S3 entrent en conduction, les diodes auxiliaires S7 et S8 se coupent automatiquement. De plus, la mise en conduction des deux diodes de Shockley auxiliaires sera pratiquement simultanée puisque leurs jonctions bloquantes correspondent à une même jonction entre le caisson 20 et le substrat 1. Cette mise en conduction quasi-simultanée entraînera par effet d'amplification une mise en conduction quasi-simultanée des diodes de Shockley principales S1 et S3.

On a également représenté en figure 6B une région N⁺ 25 à la périphérie du caisson 20. Cette région N⁺ a la fonction classique de région d'arrêt de canal et est destinée à favoriser la tenue en tension du système.

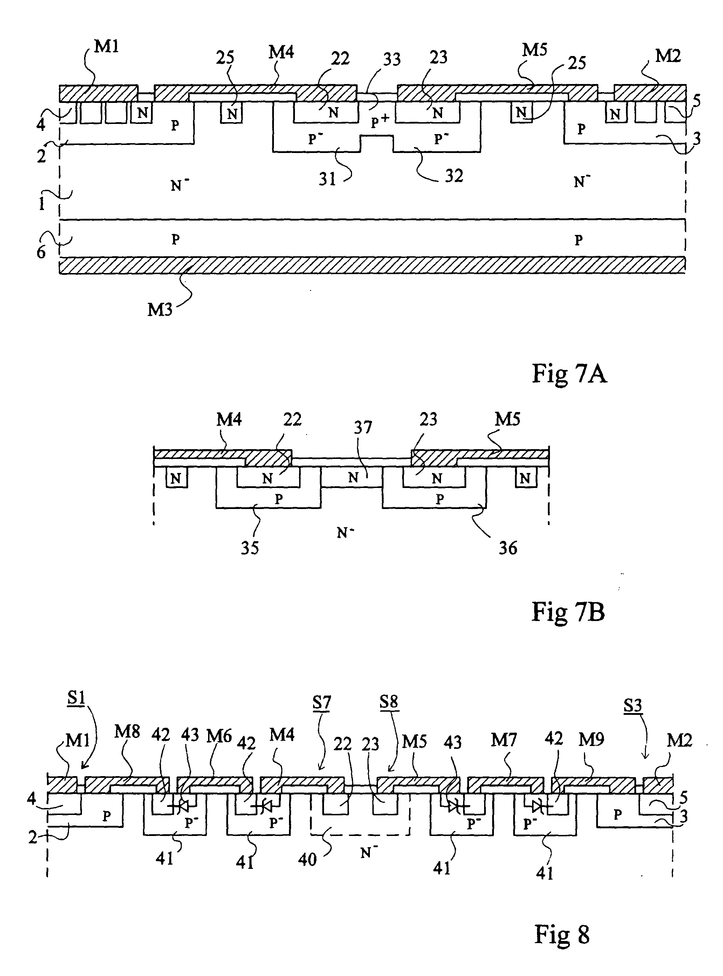

Les figures 7A et 7B représentent des variantes de réalisation de la zone d'amorçage préférentiel. Dans le mode de réalisation de la figure 7A, on notera tout d'abord que l'on a représenté schématiquement des zones de court-circuit d'émetteur dans les régions de type N 4 et 5. Comme on l'a indiqué précédemment, on doit comprendre que de tels courts-circuits d'émetteur existent dans les régions N 4 et 5 illustrées dans toutes les figures de la présente demande de brevet. De plus, dans la figure 7A, le caisson 20 est divisé en deux sous-caissons 31 et 32 dans lesquels sont respectivement formées les régions 22 et 23. Ces deux sous-caissons sont séparés par une région 33 de type P, fortement dopée (P⁺), d'un niveau de dopage plus élevé que celui des caissons 2 et 3. De plus, les deux sous-caissons 31 et 32 sont de préférence plus faiblement dopés que les caissons 2 et 3. Ainsi, l'amorçage se produira de façon préférentielle à la jonction NP⁺ entre le substrat 1 et la région 33. Le plus faible niveau de dopage des régions 31 et 32 augmente le gain des transistors NPN 22-31-1 et 23-32-1 qui interviennent dans le déclenchement de la diode de Shockley.

Dans le cas de la figure 7B, le caisson 20 est également divisé en deux sous-caissons 35 et 36. Les deux caissons 35 et 36 sont séparés par une région 37 de type N, au moins aussi dopée que les diverses régions de type N 4, 5, 22, 23. Dans ce cas, le déclenchement se produira au niveau des jonctions PN 35-37 ou 36-37 qui claquent avant les jonctions 2-1 et 3-1, la région 37 étant plus fortement dopée que le substrat 1.

Ainsi, le composant représenté en figures 6A et 6B, ou ses variantes illustrées en figures 7A et 7B, satisfont à la fonction recherchée de mise en conduction simultanée de deux diodes de Shockley bidirectionnelles oonnectées entre deux lignes et la masse quelle que soit la polarité d'une surtension apparaissant simultanément sur les deux lignes. Toutefois, de telles structures risquent d'avoir pour effet de dégrader le fonctionnement du dispositif quand une surtension survient sur une seule ligne par rapport à la masse. En ce cas, on souhaite que la diode de Shockley bidirectionnelle DS1 ou DS2 (voir figure 3) entre cette ligne et la masse entre en action avant (ou en tout cas pas après) la diode de Shockley bidirectionnelle DS3 entre les deux lignes. Ceci signifie, en se reportant au schéma de la figure 2, que les tensions d'avalanche des diodes de Shockley S5 et S6 doivent être au moins égales aux tensions d'avalanche des diodes de Shockley S1 à S4. Ceci était obtenu avec la structure de la figure 1 où les jonctions bloquantes des diodes de Shockley S5 et S6 oorrespondaient à la jonction entre l'un ou l'autre des caissons 2 et 3 et le substrat 1. Par contre, selon l'invention, du fait de l'existenoe des métallisations M4 et M5, cette jonction bloquante devient la jonction entre la région 22 ou 23 et le caisson 20 ou les sous-caissons correspondants.

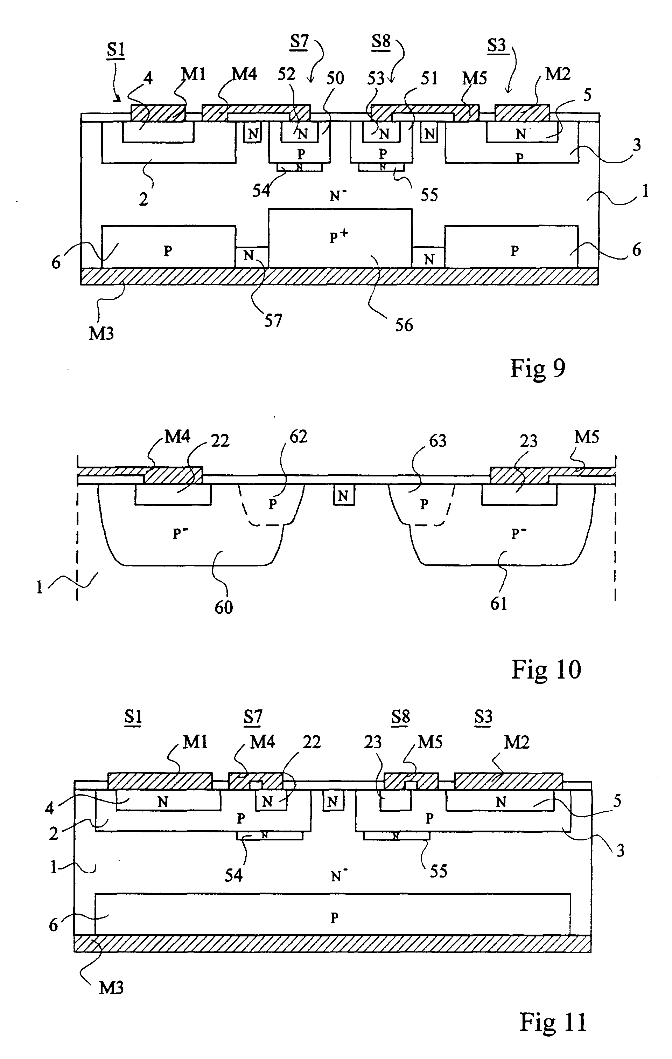

Pour éviter cet inconvénient, on peut modifier la structure de la façon illustrée en figure 8 qui est une vue partielle de la zone d'amorçage préférentiel selon la présente invention. On retrouve à droite et à gauche de la figure 8 les caissons 2 et 3 et les régions 4 et 5 qui y sont diffusées revêtues des métallisations M1 et M2. On voit également les régions de type N 22 et 23 diffusées dans une région en pointillés désignée par la référence 40 qui correspond à l'un des modes de réalisation décrits ci-dessus en relation avec les figures 6 et 7. Toutefois, les régions 22 et 23 ne sont pas directement connectées aux caissons 2 et 3 mais sont connectées à ceux-ci par l'intermédiaire de caissons intermédiaires 41 de type P dans lesquels sont diffusées des régions 42 de type N. La région de type N 22 est respectivement reliée au caisson 2 par l'intermédiaire d'une première métallisation M4 connectée à un premier caisson 41 puis d'une deuxième métallisation M6 entre une première région 42 et le caisson 41 suivant, et ainsi de suite (métallisation M8). De même, la région 23 est reliée au caisson 3 par l'intermédiaire de métallisations successives M5, M7 et M9. De préférence, les caissons 41 sont plus faiblement dopés que les caissons 2 et 3. Ceci équivaut à relier chacun des caissons 2 et 3 aux régions 22 et 23 par l'intermédiaire de diodes zener 43 qui améliorent la tenue en tension du dispositif. La figure 9 représente une autre variante de la présente invention. Au lieu d'un caisson unique 20, la zone d'amorçage préférentiel comprend deux caissons 50 et 51 de type P dans lesquels sont disposées des régions respectives 52 et 53 de type N qui sont reliées par des métallisations M4 et M5 aux caissons P 2 et 3. Les caissons 50 et 51 étant extrêmement voisins l'un de l'autre, l'amorçage de la jonction entre l'un de ces caissons et le substrat entraîne la génération de charges qui provoquent immédiatement l'amorçage de la jonction correspondante du caisson adjacent. Cette structure résoud le problème évoqué précédemment de la tenue en tension des diodes de Shockley S5 et S6.

La figure 9 illustre d'autres variantes de la présente invention qui pourraient être utilisées également dans le mode de réalisation de la figure 6A. En particulier, dans cette figure, on a prévu sous les caissons 50 et 51 des régions de type N plus fortement dopées que le substrat, respectivement 54 et 55. Une autre façon d'améliorer l'amorçage préférentiel consiste à utiliser concurremment ou séparément, du côté de la face inférieure du substrat, une zone 56 de type P plus fortement dopée et plus profonde que la région 6 de type P qui s'étend sur toute la face inférieure du substrat. Ceci entraîne une réduction de la largeur de base et une augmentation du gain des transistors PNP 56-1-50 et 56-1-51 qui oontribuent à l'amorçage des diodes de Shockley auxiliaires. La zone 56 peut être séparée de la région 6 par un anneau 57 de type N.

La figure 10 représente une autre variante de la présente invention que l'on pourra rapprocher de celle de la figure 7A ou de celle de la figure 9. A nouveau, les régions 22 et 23 sont diffusées dans des caissons distincts 60 et 61 plus faiblement dopés que les caissons 2 et 3. Dans des zones en regard des caissons 60 et 61 sont formées des régions diffusées respectives 62 et 63 résultant de la même diffusion que celle des caissons 2 et 3. Dans ce cas, l'amorçage préférentiel résulte, comme cela a été indiqué précédemment, de l'absence de trous de court-circuit d'émetteur dans les régions 22 et 23 et dans le fait que les régions 60 et 61 sont plus faiblement dopées, ce qui entraîne une augmentation du gain des transistors NPN 22-60-1 et 23-61-1. Le fait que les régions 62 et 63 sont voisines et en regard l'une de l'autre entraîne que l'amorçage de l'une provoque immédiatement l'amorçage de l'autre par injection de charges.

La figure 11 représente encore une autre variante de la présente invention dans laquelle les régions de type N 22 et 23 ne sont pas formées dans des caissons séparés mais dans des zones en regard de chacun des caissons 2 et 3. L'amorçage préférentiel se produira en raison de la présence de couches 54 et 55 de type N plus fortement dopées que le substrat disposées à l'interface entre les caissons 2 et 3 et le substrat sous les régions 22 et 23. L'amorçage préférentiel résulte aussi du fait que les régions 22 et 23 ne comprennent pas de courts-circuits d'émetteur alors que les régions 4 et 5 en comprennent. A nouveau, le déclenchement de l'une des diodes de Shockley auxiliaires 6-1-54-2-22 ou 6-1-55-2-23 provoque le déclenchement de l'autre en raison de leur proximité et des diffusions de charges qui en résultent.

Bien que la présente invention ait été décrite dans le cadre de modes de réalisation particuliers, elle est susceptible de nombreuses variantes qui apparaîtront à 1'homme de l'art habitué du domaine des composants de protection et des thyristors, en restant dans le domaine des revendications ci-après, notamment en ce qui concerne les moyens d'isolement et les périphéries des composants qui n'ont pas été décrits avec précision ici. Les composants pourront par exemple être de type mésa plutôt que planar, à caisson... En outre, les diverses variantes de réalisation du composant de protection selon la présente invention pourront être combinées entre elles, en restant dans le domaine des revendications ci-après.

## Revendications

1. Composant semi-conducteur de protection comprenant une première région d'un premier type de conductivité (1) et au moins deux paires de diodes de Shockley principales (S1, S2, S3, S4), chaque paire comprenant deux diodes en anti-parallèle connectées entre une métallisation de face avant (M1, M2) et une métallisation de face arrière (M3) du composant, la métallisation de face arrière étant commune aux deux paires de diodes, **caractérisé en ce que** chacune des diodes (S1, S3) dont la jonction bloquante dans le sens direct correspond à l'interface entre la première région et, respectivement, une deuxième et une troisième région distinctes du deuxième type de conductivité (2, 3) du côté de la face avant est associée à au moins une diode de Shockley auxiliaire (S7, S8) de même polarité et à seuil d'amorçage plus faible montée en gâchette amplificatrice sur sa diode de Shockley principale associée, et dont le déclenchement provoque celui de l'autre diode de Shockley auxiliaire et des diodes de Shockley principales associées.

2. Composant selon la revendication 1, **caractérisé en ce que** les deuxième (2) et troisième (3) régions du deuxième type de conductivité sont formées dans la première région et occupent chacune sensiblement la moitié de la surface du composant, le composant comprenant en outre :
une quatrième (4) et une cinquième (5) région du premier type de conductivité, munies de trous de court-circuit, formées respectivement dans chacune des deuxième et troisième régions, occupant chacune sensiblement la moitié de la surface de la deuxième ou de la troisième région ;
une sixième région (6) du deuxième type de conductivité, du côté de la face arrière du composant, formée dans la première région et occupant sensiblement toute la surface du composant ;
une septième région (7) du premier type de conductivité, munie de trous de court-circuit, formée dans la sixième région et sensiblement complémentaire en projection dans le plan principal du composant des quatrième et cinquième régions ;
un premier contact (M1) connecté aux deuxième et quatrième régions ;
un deuxième contact (M2) connecté aux troisième et cinquième régions ;
un troisième contact (M3) connecté aux sixième et septième régions ;
les première et deuxième diodes de Shockley principales (S1, S2) en anti-parallèle étant formées entre les premier et troisième contacts et les troisième et quatrième diodes de Shockley principales (S3, S4) en anti-parallèle étant formées entre les deuxième et troisième contacts, la première diode de Shockley principale (S1) correspondant aux quatrième, deuxième, première et sixième régions, et la troisième diode de Shockley principale (S3) correspondant aux cinquième, troisième, première et sixième régions.

3. Composant selon la revendication 2, **caractérisé en ce que** les diodes de Shockley auxiliaires (S7, S8) comprennent une huitième région (20) du deuxième type de conductivité, formée dans la première région et voisine des deuxième et troisième régions, et des neuvième (22) et dixième (23) régions du premier type de conductivité sans trous de court-circuit, disposées dans la huitième région, les neuvième et dixième régions étant respectivement connectées aux deuxième et troisième régions (2 et 3).

4. Composant selon la revendication 3, **caractérisé en ce qu'**il comprend en outre des onzièmes régions (41) du deuxième type de conductivité formées dans la face supérieure du substrat et des douzièmes régions (42) du premier type de conductivité formées chacune dans une onzième région, chaque ensemble de onzième et douzième régions formant une diode Zener, la connexion entre chacune des neuvième et dixième régions (22, 23) et chacune des deuxième et troisième régions (2 et 3) se faisant par l'intermédiaire desdites diodes Zener, respectivement.

5. Composant selon la revendication 3, **caractérisé en ce qu'**une treizième région (54, 55) du premier type de conductivité, plus dopée que le substrat et disposée à l'interface entre la huitième région (50, 51) et la première région (1).

6. Composant selon la revendication 3, **caractérisé en ce que** la huitième région est divisée en deux sous-régions (31, 32) moins dopées que les deuxième et troisième régions, séparées par une région 33 du deuxième type de conductivité plus dopée que les deuxième et troisième régions.

7. Composant selon la revendication 3, **caractérisé en ce que** la huitième région est divisée en deux sous-régions (35, 36) moins dopées que les deuxième et troisième régions, séparées par une région (37) du premier type de conductivité plus dopée que la première région (1).

8. Composant selon la revendication 3, **caractérisé en ce que** la huitième région est divisée en deux sous-régions (60, 61) moins dopées que les deuxième et troisième régions et ayant des zones en regard comprenant une région (62, 63) du deuxième type de conductivité dopée comme les deuxième et troisième régions.

9. Composant selon la revendication 3, **caractérisé en ce que** la sixième région (6) comprend, en regard de la huitième région (50, 51), une zone (56) plus dopée et plus profonde que le reste de la sixième région.

10. Composant selon la revendication 2, **caractérisé en ce que** des neuvième et dixième régions (22, 23) sont disposées dans les deuxième et troisième régions (2, 3), respectivement, et **en ce que** des quatorzièmes régions (54, 55) du premier type de conductivité plus dopées que le substrat sont prévues à l'interface entre les deuxième et troisième régions et la première région (1), sous les neuvième et dixième régions.

## Patentansprüche

1. Halbleiter-Schutzbauteil, welches einen ersten Bereich (1) eines ersten Leitfähigkeitstyps und wenigstens zwei Paare von Haupt-Shockleydioden (S1,S2,S3,S4) umfaßt, wobei jedes Paar jeweils zwei Dioden in Antiparallelschaltung zwischen einer Vorderseiten-Metallisierung (M1, M2) und einer Rück- bzw. Unterseiten-Metallisierung (M3) des Bauteils umfaßt und die Rück- bzw. Unterseiten-Metallisierung den beiden Diodenpaaren gemeinsam ist, **dadurch gekennzeichnet, daß** jede der Dioden (S1, S3), deren in Durchlaßrichtung sperrender P,N-Übergang der Grenzfläche zwischen dem ersten Bereich und jeweils einem distinkten zweiten bzw. dritten Bereich (2, 3) vom zweiten Leitfähigkeitstyp auf der der Vorderseite zugewandten Seite entspricht, wenigstens einer Hilfs-Shockleydiode (S7,S8) derselben Polarität und mit niedrigerer Triggerschwelle zugeordnet ist, die als Gate-Verstärker über ihrer zugeordneten Shockley-Hauptdiode geschaltet ist, und deren Auslösung bzw. Triggerung die Triggerung der anderen Shockleyhilfsdiode und der zugeordneten Haupt-Shockleydioden hervorruft.

2. Bauteil nach Anspruch 1, **dadurch gekennzeichnet, daß** der zweite (2) und der dritte (3) Bereich vom zweiten Leitfähigkeitstyp in dem ersten Bereich ausgebildet sind und jeder jeweils im wesentlichen die Hälfte der Fläche des Bauteils einnimmt, und daß das Bauteil des weiteren umfaßt:
einen vierten (4) und einen fünften (5) Bereich vom ersten Leitfähigkeitstyp, die mit Kurzschluß-Löchern versehen sind und jeweils in jedem zweiten bzw. dritten Bereich ausgebildet sind und jeder jeweils im wesentlichen die Hälfte der Fläche des zweiten oder des dritten Bereichs einnehmen;
einen sechsten Bereich (6) vom zweiten Leitfähigkeitstyp, der auf der der Bauteilrückseite zugewandten Seite in dem ersten Bereich ausgebildet ist und im wesentlichen die gesamte Fläche des Bauteils einnimmt;
einen siebenten Bereich (7) vom ersten Leitfähigkeitstyp, der mit Kurzschluß-Löchern versehen ist und in dem sechsten Bereich ausgebildet ist und in Projektion in der Hauptebene des Bauteils im wesentlichen komplementär zu dem vierten und fünften Bereich ist;
einen mit dem zweiten und dem vierten Bereich verbundenen ersten Kontakt (M1);
einen mit dem dritten und dem fünften Bereich verbundenen zweiten Kontakt (M2);
einen mit dem sechsten und dem siebenten Bereich verbundenen dritten Kontakt (M3);
wobei die erste und die zweite Haupt-Shockley-Diode (S1, S2) in Antiparallel-Anordnung zwischen dem ersten und dem dritten Kontakt ausgebildet sind und die dritte und die vierte Haupt-Shockley-Diode (S3, S4) in Antiparallel-Anordnung zwischen dem zweiten und dem dritten Kontakt ausgebildet sind, und wobei die erste Haupt-Shockley-Diode (S1) dem vierten, zweiten, ersten und sechsten Bereich entspricht und die dritte Haupt-Shockley-Diode (S3) dem fünften, dritten, ersten und sechsten Bereich entspricht.

3. Bauteil nach Anspruch 2, **dadurch gekennzeichnet, daß** die Hilfs-Shockley-Dioden (S7, S8) einen in dem ersten Bereich und benachbart dem zweiten und dritten Bereich ausgebildeten achten Bereich (20) vom zweiten Leitfähigkeitstyp sowie in dem achten Bereich angeordnete neunte (22) und zehnte (23) Bereiche vom ersten Leitfähigkeitstyp ohne Kurzschluß-Löcher umfassen, wobei der neunte bzw. zehnte Bereich mit dem zweiten bzw. dritten Bereich (2 und 3) verbunden sind.

4. Bauteil nach Anspruch 3, **dadurch gekennzeichnet, daß** es des weiteren in der Oberseite des Substrats ausgebildete elfte Bereiche (41) vom zweiten Leitfähigkeitstyp sowie jeweils in einem elften Bereich ausgebildete zwölfte Bereiche (42) vom ersten Leitfähigkeitstyp umfaßt, wobei jeweils jedes Aggregat aus elftem und zwölftem Bereich eine Zenerdiode bildet und die Verbindung zwischen jedem neunten und zehnten Bereich (22, 23) und jedem zweiten und dritten Bereich (2 und 3) jeweils über die genannten Zenerdioden erfolgt.

5. Bauteil nach Anspruch 3, **dadurch gekennzeichnet, daß** ein stärker als das Substrat dotierter dreizehnter Bereich (54, 55) vom ersten Leitfähigkeitstyp an der Grenzfläche zwischen dem achten Bereich (50, 51) und dem ersten Bereich (1) angeordnet ist.

6. Bauteil nach Anspruch 3, **dadurch gekennzeichnet, daß** der achte Bereich in zwei Unterbereiche (31, 32) unterteilt ist, die schwächer als der zweite und der dritte Bereich dotiert sind und durch einen stärker als der zweite und der dritte Bereich dotierten Bereich (33) vom zweiten Leitfähigkeitstyp getrennt sind.

7. Bauteil nach Anspruch 3, **dadurch gekennzeichnet, daß** der achte Bereich in zwei Unterbereiche (35, 36) unterteilt ist, die schwächer als der zweite und der dritte Bereich dotiert sind und durch einen stärker als der erste Bereich (1) dotierten Bereich (37) vom ersten Leitfähigkeitstyp getrennt sind.

8. Bauteil nach Anspruch 3, **dadurch gekennzeichnet, daß** der achte Bereich in zwei Unterbereiche (60, 61) unterteilt ist, die schwächer als der zweite und dritte Bereich dotiert sind und einander gegenüberstehende Zonen mit einem Bereich (62, 63) vom zweiten Leitfähigkeitstyp aufweisen, der wie der zweite und der dritte Bereich dotiert ist.

9. Bauteil nach Anspruch 3, **dadurch gekennzeichnet, daß** der sechste Bereich (6) gegenüber dem achten Bereich (50, 51) eine Zone (56) aufweist, die stärker dotiert und tiefer als der übrige Teil des sechsten Bereichs ist.

10. Bauteil nach Anspruch 2, **dadurch gekennzeichnet, daß** der neunte bzw. zehnte Bereich (22, 23) in dem zweiten bzw. dritten Bereich (2, 3) angeordnet sind und daß an der Grenzfläche zwischen den zweiten und dritten Bereichen und dem ersten Bereich (1) unter dem neunten und dem zehnten Bereich vierzehnte Bereiche (54, 55) vom ersten Leitfähigkeitstyp vorgesehen sind, die stärker als das Substrat dotiert sind.

## Claims

1. A protection semiconductor component including a first region (1) of a first conductivity type and at least two pairs of main Shockley diodes (S1, S2, S3, S4), each pair including two parallel diodes, head-to-tail connected between a front surface metallization (M1, M2) and a rear surface metallization (M3) of the component, the rear surface metallization being common to the two pairs of diodes, **characterized in that** each of the diodes (S1, S3) whose blocking junction in direct polarization corresponds to the interface between the first region and, respectively, a second and a third distinct region of the second conductivity type (2, 3) on the side of the front surface is associated with at least one auxiliary Shockley diode (S7, S8) having the same polarity and a lower triggering threshold connected as a gate amplifier with the associated main Shockley diode, and the triggering of one auxiliary diode thus causing the triggering of the other auxiliary diode and of the associated main Shockley diodes.

2. The component of claim 1, **characterized in that** the second (2) and third (3) regions of the second conductivity type are formed in the first region and occupy approximately one half of the surface of the component, the component further comprising:
a fourth (4) and a fifth (5) region of the first conductivity type, including shorting holes, respectively formed in each second and third region, each occupying substantially one half of the surface of the second or third region;
a sixth region (6) of the second conductivity type, on the side of the rear surface of the component, formed in the first region and occupying substantially the whole surface of the component;
a seventh (7) region of the first conductivity type, provided with shorting holes and formed in the sixth region and that substantially complement, in projection in the main plane of the component, the fourth and fifth regions;
a first contact (M1) connected to the second and fourth regions;
a second contact (M2) connected to the third and fifth regions;
a third contact (M3) connected to the sixth and seventh regions;
the first and second parallel, head-to-tail, main Shockley diodes (S1, S2) being formed between the second and third contacts, and the third and fourth parallel, head-to-tail, main Shockley diodes (S3, S4) being formed between the second and third contacts, the first Shockley diode (S1) corresponding to the fourth, second, first and sixth regions, and the third main Shockley diode (S3) corresponding to the fifth, third, first and sixth regions.

3. The component of claim 2, **characterized in that** the auxiliary Shockley diodes (S7, S8) include an eighth region (20) of the second conductivity type, formed in the first region and adjacent to the second and third regions, and ninth (22) and tenth (23) regions of the first conductivity type, without shorting holes, that are disposed in the eighth region, the ninth and tenth regions being connected to the second and third regions (2, 3), respectively.

4. The component of claim 3, **characterized in that** it further includes eleventh regions (41) of the second conductivity type formed in the upper surface of the substrate, and twelfth regions (42) of the first conductivity type, each formed in an eleventh region, each sets of an eleventh region and a twelfth region forming a Zener diode, the connection between each ninth and tenth regions (22, 23) and each second and third regions (2, 3) being made through said Zener diodes, respectively.

5. The component of claim 3, **characterized in that** a thirteenth region (54, 55) of the first conductivity type, more highly doped than the substrate, is disposed at the interface between the eighth region (50, 51) and the first region (1).

6. The component of claim 3, **characterized in that** the eighth region is partitioned into two sub-regions (31, 32), having a lower doping level than the second and third regions, separated by a region (33) of the second conductivity type more highly doped than the second and third regions.

7. The component of claim 3, **characterized in that** the eighth region is partitioned into two sub-regions (35, 36), having a lower doping level than the second and third regions, separated by a region (37) of the first conductivity type, more highly doped than the first region (1).

8. The component of claim 3, **characterized in that** the eighth region is partitioned into two sub-regions (60, 61), having a lower doping level than the second and third regions, and having facing areas including a region (62, 63) of the second conductivity type, having the same doping level as the second and third regions.

9. The component of claim 3, **characterized in that** the sixth region (6) includes, facing the eighth region (50, 51), a region (56) deeper and having a higher doping level than the remaining parts of the sixth region.

10. The component of claim 2, **characterized in that** ninth and tenth regions (22, 23) are disposed in the second and third regions (2, 3), respectively, and fourteenth regions (54, 55) of the first type of conductivity, having a higher doping level than the substrate, are disposed at the interface between the second and third regions and the first region (1), beneath the ninth and tenth regions.
